# EUROPEAN PATENT APPLICATION

(11) **EP 4 779 345 A1**
(43) Date of publication of application: **22.07.2026**
(21) Application number: 25153182.8
(22) Date of filing: 21.01.2025
(51) Int. Cl.: G01R 33/38, G01R 33/3815, H01H 50/10

(54) **MAGNETICALLY ACTUATED CONTACTOR AND MAGNETIC RESONANCE IMAGING DEVICE**

(71) Applicant: Koninklijke Philips N.V., 5656 AE Eindhoven (NL)
(72) Inventor: GALIOTO, Steven Joseph, Eindhoven (NL); URBAHN, John Arthur, Eindhoven (NL); FORTHMANN, Peter, 5656AG Eindhoven (NL); QUAGLIANA, Michael John, Eindhoven (NL)
(74) Representative: Philips Intellectual Property & Standards

(57) **Abstract**

A magnetic resonance imaging (MRI) device (100) includes an electrically superconductive coil having an opening to receive a subject, and a magnetically-actuated contactor 306. The magnetic contactor (306) has a ferromagnetic plunger (320) and a ferromagnetic yoke (302) disposed over the ferromagnetic plunger (320). The ferromagnetic yoke (302) has four sides, with two of the four sides (312, 316) have substantially less surface area than the other two of the four sides. An external magnetic field is oriented to be substantially perpendicularly to the two sides (312,316) having substantially less surface area.

## Description

### BACKGROUND OF THE INVENTION

Magnetic Resonance Imaging (MRI) devices comprise superconducting magnets used to generate the DC magnetic fields needed for MR imaging. Typical MR magnets comprise main coils and shield coils, with the main coils adapted to generate the main magnetic field and the shield coils adapted to shield the MRI device from stray fields often generated by gradient coils of the MRI device.

In certain known MRI devices, the superconducting magnets are designed to be energized via a power supply. This step, known as ramping up is carried out until the magnet is fully energized. After ramp-up the magnets are disconnected from the power supply to reduce potential thermal issues that can adversely impact the function of the superconducting magnet. In certain known devices, a magnetically-actuated contactor functions as the switch to disconnect the power supply after ramp-up. This contactor thereby provides a thermal disconnect between the external magnet leads and the superconducting leads within the magnet's energization lead chain. This thermal disconnect prevents heat from leaking into the magnet and causing the superconducting wire to quench.

As described more fully below, in certain MRI devices, the contactor is disposed in proximity to the superconducting magnet. Because the contactor is magnetically actuated, the time invariant (DC) magnetic field generated by the superconducting magnet can adversely impact the function of the actuator. Specifically, this background magnetic field can affect the ability of the contactor to close and open, and thus impact its ability to connect the power supply to the magnet, and to disconnect the power supply after ramp-up or in an emergent situation.

What is needed, therefore, is a device that overcomes at least the noted drawbacks of the known approaches described above.

### SUMMARY OF THE INVENTION

In accordance with a representative embodiment, a magnetically-actuated contactor comprises: a ferromagnetic plunger; and a ferromagnetic yoke disposed over the ferromagnetic plunger, the ferromagnetic yoke comprising four sides, with two of the four sides have substantially less surface area than the other two of the four sides. An external magnetic field is oriented to be substantially perpendicular to the two sides having substantially less surface area.

In accordance with another representative embodiment, the apparatus comprises a ferromagnetic shield disposed over the ferromagnetic yoke and substantially covering the four sides of the ferromagnetic yoke. The ferromagnetic shield shunts at least a portion of the external magnetic field.

In accordance with another representative embodiment, a magnetic resonance imaging (MRI) device comprises: an electrically superconductive coil having an opening to receive a subject, and an apparatus. The apparatus comprises: a magnetically actuated contactor; and a ferromagnetic yoke disposed over the contactor. The ferromagnetic yoke comprises four sides and two of the four sides have substantially less surface area than the other two of the four sides. An external magnetic field is oriented to be substantially perpendicular to the two sides having substantially less surface area, and the ferromagnetic yoke shunts at least a portion the external magnetic field away from the contactor.

In accordance with another representative embodiment, the apparatus comprises a ferromagnetic shield disposed over the ferromagnetic yoke and substantially covering the four sides of the ferromagnetic yoke. The ferromagnetic shield shunts at least a portion of the external magnetic field.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 is a perspective view of a magnetic resonance imaging (MRI) system in accordance with a representative embodiment.
Fig. 2A is a perspective view showing the known orientation of the B field relative to the contactor comprising a ferromagnetic yoke.
Figs. 2B-2C show a contactor comprising a ferromagnetic yoke in a known magnetic field orientation, and the B field density in the ferromagnetic yoke before and during operation of an MRI apparatus.
Fig. 3A is a perspective view of a contactor comprising a ferromagnetic yoke and showing a B field orientation relative to the ferromagnetic yoke in accordance with a representative embodiment.
Figs. 3B-3D show the B field density in the ferromagnetic yoke during operation of an MRI apparatus in accordance with a representative embodiment.
Fig. 4A a perspective view of a contactor comprising a ferromagnetic shield disposed over a ferromagnetic yoke in accordance with a representative embodiment.
Fig. 4B is a top view of the contactor of Fig. 4A showing B field flux lines traversing the ferromagnetic shield in accordance with a representative embodiment.

### DETAILED DESCRIPTION OF EMBODIMENTS

In the following detailed description, for the purposes of explanation and not limitation, representative embodiments disclosing specific details are set forth in order to provide a thorough understanding of embodiments according to the present teachings. However, other embodiments consistent with the present disclosure that depart from specific details disclosed herein remain within the scope of the appended claims. Descriptions of known systems, devices, materials, methods of operation and methods of manufacture may be omitted so as to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only and is not intended to be limiting. Definitions and explanations for terms herein are in addition to the technical and scientific meanings of the terms as commonly understood and accepted in the technical field of the present teachings.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

As used in the specification and appended claims, the singular forms of terms 'a', 'an' and 'the' are intended to include both singular and plural forms, unless the context clearly dictates otherwise. Additionally, the terms "comprises," and/or "comprising," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to", "coupled to", or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" or "immediately adjacent" to another element or component, this encompasses only cases where the two elements or components are connected or disposed immediately adjacent to each other without any intermediate or intervening elements or components.

As used herein, "substantially less surface area" means the surface area comprises a surface area that is approximately equal to twice the thickness of the ferromagnetic yoke.

As described herein in connection with various representative embodiments, a ferromagnetic yoke is oriented to reduce the adverse impact of a DC magnetic field on the function of a magnetically actuated contactor. In certain embodiments, the contactor is a component of a magnetic resonance imaging (MRI). Generally, the ferromagnetic yoke is oriented in the DC magnetic field in such a way that the DC magnetic field does not saturate the ferromagnetic yoke as significantly as other known orientations of the ferromagnetic yoke relative to the magnetic field. In other embodiments, a ferromagnetic shield is provided over the ferromagnetic yoke and provides additional protection against saturation of the ferromagnetic yoke and reduced or eliminated function of the magnetically -actuated contactor.

Generally, the yoke and the shield of the various representative embodiments described herein comprises a ferromagnetic material. The ferromagnetic materials selected for use as the yoke and the shield have a magnetic permeability and saturation induction that is high compared to the materials used for the components of the contactor. In this way, and as described more fully below, the ferromagnetic shield provides a path of lesser magnetic "resistance" enabling the ferromagnetic shield to shunt magnetic flux of the DC magnetic field in a manner that its adverse impact on the function of magnetically actuated components of the contactor is reduced. Stated somewhat differently, the high magnetic permeability (µₘ) and saturation induction (Bₛ) are selected so the ferromagnetic shield is adapted to carry a greater magnetic flux from the DC magnetic field of the magnet into which the contactor is immersed to shunt the DC magnetic field around the magnetically actuated components of the contactor. In this way the function of the contactor is inhibited to a lesser extent, if even appreciably, compared to its function when not immersed in a DC magnetic field. In certain representative embodiments, the opening force of the contactor when protected by the ferromagnetic yoke is approximately 94% of the opening force when no DC magnetic field is present. In other representative embodiments the combination of the ferromagnetic yoke and the ferromagnetic shield result in the opening force's being approximately 98.5% of the opening force when no DC magnetic field is present.

As noted above, the materials selected for the ferromagnetic yoke and the ferromagnetic shield have a comparatively high saturation induction (Bs) in the range of approximately 2 Tesla. Illustrative materials include, but are not limited to Iron, Nickel, Cobalt, Neodymium, and magnetite (Fe₃O₄). Ferromagnetic alloys are also contemplated for use in the ferromagnetic yoke and ferromagnetic shield, including, but not limited to an alloy of carbon-steel, silicon-steel, permalloy (iron and nickel) or alnico (aluminum, nickel and cobalt).

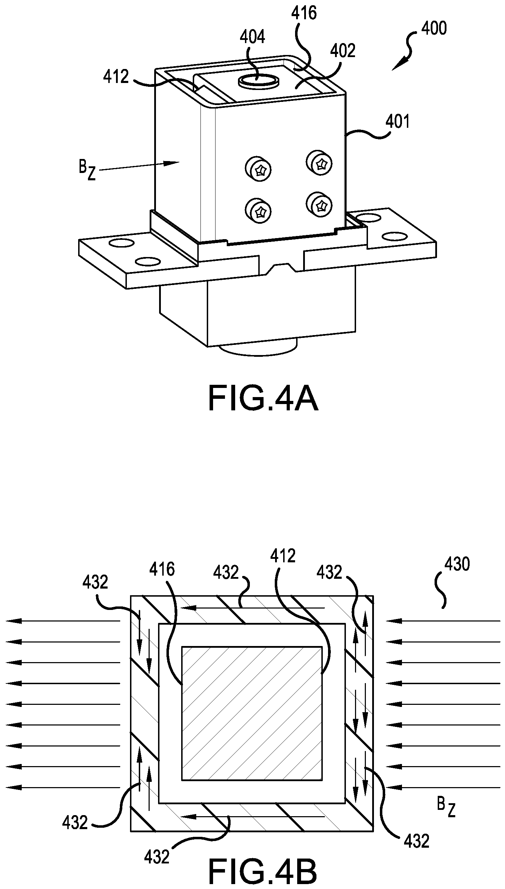

The comparatively high magnetic permeability of the ferromagnetic yoke and the ferromagnetic shield and appropriately chosen dimensions of the ferromagnetic yoke and ferromagnetic shield are required to improve shielding and therefore provide at least an acceptable closing/latching force of the magnetically actuated contactor. Specifically, the length, width and thickness of the materials used for the ferromagnetic shield are selected to optimize the latching force. To this end, and as described more fully below, the thickness of the material used for the ferromagnetic shield is selected to reduce the flux density induced in the ferromagnetic yoke when the ferromagnetic yoke is oriented relative to the DC magnetic field in accordance with various representative embodiments described herein. As shown in Figs. 4A and 4B, the length and width of the ferromagnetic shield are chosen to be slightly larger than the dimensions of the ferromagnetic yoke and may be refined through iterations of electromagnetic simulations. For cost-saving reasons, raw stock material dimensions may be selected. Just by way of illustration, in certain representative embodiments, the ferromagnetic shield has a thickness in the range of approximately 2 mm to approximately 8 mm; and have a length and a width of approximately 60 mm x 60 mm.

Various representative embodiments are described below to illustrate various aspects of the present teachings. The ferromagnetic yoke and ferromagnetic shield can be used around a variety of magnetic actuators and is not constrained to the contactor described below. The magnetic ferromagnetic shield may be rectangular, cylindrical or any shape, although certain shapes and dimensions are optimal. Notably, while there are certain functional benefits to using a cylindrical shape for the ferromagnetic shield and ferromagnetic yoke over those with a rectangular shape, the dimensions for the shield are selected to be disposed over the ferromagnetic yoke. By minimizing the surface area of the ferromagnetic shield that is perpendicular to the magnetic field, the thickness of the ferromagnetic shield is minimized. This provides the advantage of the least amount of shield mass and cost.

The magnetic ferromagnetic shield can be affixed to the actuator in any means possible as long as it surrounds the magnetically susceptible portion of the actuator.

The magnetic ferromagnetic shield may or may not completely envelope the entire actuator. For example, and as described in connection with Figs. 4A and 4B, the ferromagnetic shield is open structure with one side open. This can be realized using stock rectangular tubing that can be cut into sections, thereby providing both convenience of assembly and cost benefits.

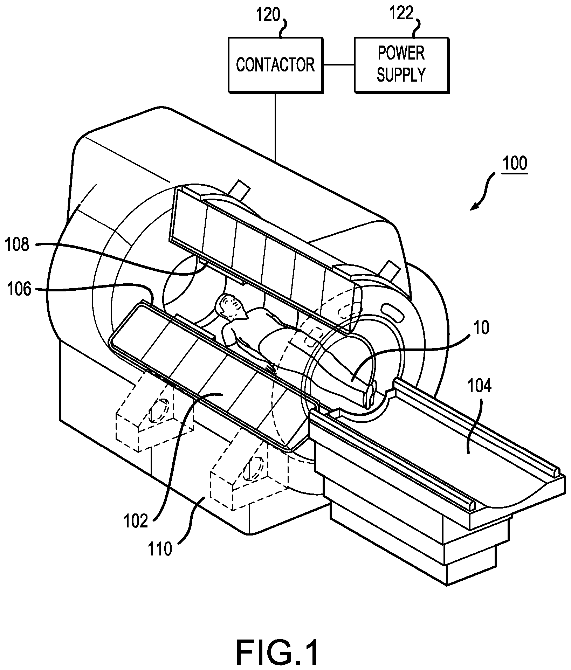

Fig. 1 is a perspective view of a magnetic resonance imaging (MRI) device 100 of a representative embodiment 100. The MRI device 100 comprises a superconducting magnet apparatus 102; a patient table 104 configured to hold a patient 10; electrically superconducting coils 106 configured to at least partially surround at least a portion of patient 10 for which MRI device 100 generates an image; a radio frequency coil 108 configured to apply a radio frequency signal to at least the portion of patient 10 which is being imaged, and to alter the alignment of the magnetic field. The general operation of an MRI device is known and many aspects of the MRI device are not repeated herein.

As alluded to above, certain superconducting magnets, such as so-called sealed magnets, are adapted to connect to a power supply 122 via a contactor 120. Such sealed magnets include, but are not limited to BlueSeal^{™} magnets commercially available from Koninklijke Philips, N.V. The connection to the power supply 122 creates a thermal path, which can adversely impact the function of the electrically superconducting coils 106. As such, after ramp-up to the desired energized state, the power supply is disconnected via the contactor 120. As described below, in connection with certain representative embodiments, the contactor comprises a plunger (not shown in Fig. 1), which is magnetically actuated that closes a gap in the contactor 120 to effect a connection with the power supply to energize/ramp up the superconducting coils. When the plunger is in this closed position, not only is current able to flow to energize the superconducting coils of the MRI magnet, but also provides a thermal path that can adversely impact the function of the superconducting coils 106, which must be maintained at a comparatively low temperature (e.g., 4.2 K) to reach a superconductive state. Accordingly, after ramp-up is completed, it is beneficial, if not essential, to break the thermal path between the superconducting coils 106 and the power supply 122.

As will be appreciated by one of ordinary skill in the art, the superconducting coils 106, when energized provide a substantially time-invariant (direct current (DC)) magnetic field used to carry out the imaging. This magnetic field (sometimes referred to as "DC field") is comparatively strong (just by way of example, 0.1T to 3T) to effect the imaging. This DC magnetic field can directly interfere with the function of the plunger. Specifically, the ferromagnetic yoke of the contactor magnetically actuates the plunger to connect and disconnect the superconducting coils 106 as needed. The DC magnetic field can saturate the ferromagnetic yoke, and inhibit the function of the plunger and interfere if not terminate the movement of the plunger. As will be appreciated, when the plunger does not function properly, the ability to connect and disconnect the power supply 122 from the superconducting coils, thereby deleteriously impacting the ability to energize the superconducting coils 106 when needed, and to create a break in the thermal path once ramp-up is completed.

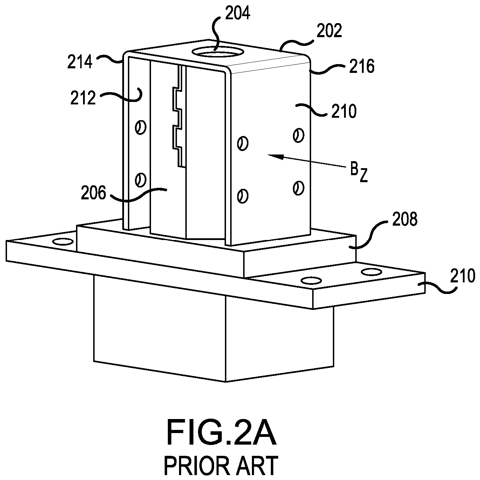

Fig. 2A is a perspective view showing the known orientation of a DC magnetic field (shown as B_{z}) relative to contactor 206 comprising a ferromagnetic yoke 202. A plunger (not shown in Fig. 2A) described more fully below is adapted to be raised to make a connection to a power supply (not shown in Fig. 2A) and lowered to disconnect the power supply and break the thermal path as needed.

The ferromagnetic yoke 202 is made of a ferromagnetic material, with a permanent magnet 204 adapted to function in the magnetic actuation of the plunger of the contactor 206 to make and break the electrical connection. As shown, the contactor 206 is disposed on a base 208, which illustratively comprises plastic with a ferromagnetic element (not shown) embedded therein that comprises a ferromagnetic material.

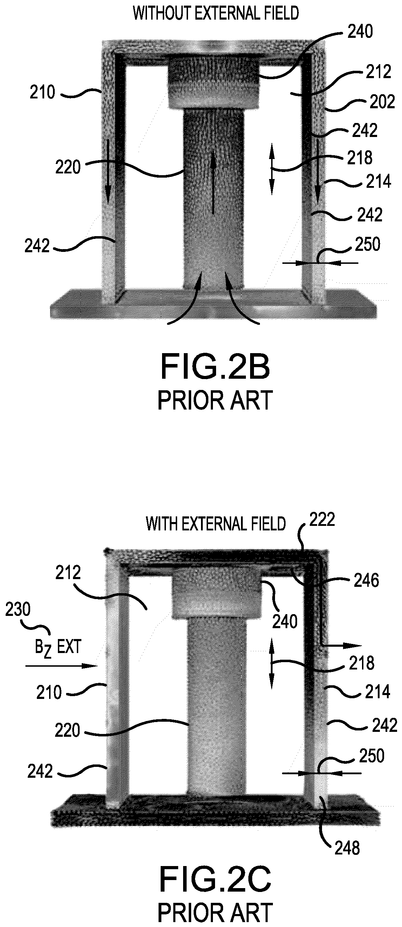

As will be appreciated by one of ordinary skill in the art, a magnetic field traverses the ferromagnetic yoke 202 and is used to effect the mechanical actuation of the plunger. A coil (not shown) embedded in the contactor 206 is used to create a magnetic flux that links the ferromagnetic plunger and the ferromagnetic yoke. In other words, as shown in Fig. 2B with arrows in the plunger 220 and ferromagnetic yoke 202, the flux flows through the plunger in one direction and returns through the ferromagnetic yoke. When the coil is energized to allow current to flow in one direction, the plunger to be attracted to the permanent magnet 204.

Notably, the contactor 206 comprises an internal spring (not shown) that assists in closing the contactor 206. As described more fully below, the spring counters the electromagnetic force needed to open the contactor 206. So, the electromagnetic force needed to open the contactor 206 is generally greater than the electromagnetic force needed to close the contactor. When disposed in a DC magnetic field having the orientation of Figs. 2A and 2C, the contactor 206 cannot not generate enough opening force. As noted above, and as described more fully below in accordance with various representative embodiments, these issues with reduced opening forces are overcome and enable the contactor to function properly in the presence of a DC magnetic field (e.g., generated by superconducting coils use in an MRI magnet).

As shown in Fig. 2A, and as described more fully below in connection with Figs. 2B and 2C, the ferromagnetic yoke comprises four sides. Two of the sides 210, 214 are substantially solid, and two of the sides 212, 216 are substantially "open." Stated somewhat differently, two open sides 212, 216 have substantially less surface area than the surface area of the two solid sides 210, 214. Rather, and as shown more clearly and described more fully below, the surface area of the two surface area comprises a surface area that is approximately equal to twice the thickness of the ferromagnetic yoke 202. Notably, the thickness of the ferromagnetic yoke 202, which is seen in Fig. 2A, is shown between arrows as 250 in Figs. 2B-2C. As will be appreciated, the surface area of twice the thickness of the ferromagnetic yoke is small compared to the surface area of the sides 210, 214.

As shown, in the known structure of Fig. 2A, the DC magnetic field generated by the superconducting coils is oriented to be incident substantially perpendicular to sides 210, 214 of the ferromagnetic yoke 202. As described below in connection with Fig. 2C when the DC magnetic field is applied in this manner, the ferromagnetic yoke 202 becomes saturated, and the function of the plunger is compromised. Notably, the in other representative embodiments, the DC magnetic field is not oriented perpendicularly to sides 210, 214 of the ferromagnetic yoke. To a lesser extent than perpendicular orientation, these other angles of incidence may also result in the function of the plunger to be compromised.

Figs. 2B-2C show a contactor comprising a ferromagnetic yoke in a known magnetic field orientation, and the B field density in the ferromagnetic yoke before and during operation of an MRI apparatus. Notably, other components of the contactor 206 are not shown in Figs. 2B-2C.

Turning to Fig. 2B, when the DC magnetic field is not turned on, the function of a plunger 220 is not adversely impacted. Specifically, darker regions such as first region 240 and second region 242 show a region of higher magnetic flux used to cause the magnetic actuation of the contactor. Stated somewhat differently, the arrows shown in the plunger 220 and the ferromagnetic yoke 202 show the direction of the magnetic flux. This magnetic field raises and lowers the plunger 220 (shown by arrows 218) causing the electrical connection and disconnection, respectively, of the power supply (not shown in Fig. 2B) to the superconducting coils of the magnet (not shown in Fig. 2C).

Turning to Fig. 2C, when the DC magnetic field is turned on and incident on the side 210 of the ferromagnetic yoke 202. In this case, the magnetic flux from the DC magnetic field is shunted by the ferromagnetic yoke 202, but is significantly greater than the magnetic field used to actuate the plunger 220 of the contactor 206. Specifically, the first and second regions 240, 242, which were comparatively dark in Fig. 2B when the DC magnetic field was off, are no longer dark. By contrast, regions 246 and 248 are dark when compared to these regions in Fig. 2B. (This is also shown in Fig. 2C by the arrow shown in the ferromagnetic yoke 202 indicating the direction of the magnetic flux.) This is indicative of the magnetic flux in the ferromagnetic yoke 202 caused by the DC magnetic field. Plainly, the magnetic flux in first and second regions 242, 244, which in Fig. 2B show the flux used to move the plunger 220 along arrows 218, is significantly reduced in these regions in Fig. 2C. This increase in the magnetic flux in regions 246, 248 by the DC magnetic field from the superconducting coils of the magnet significantly impacts the magnetic flux needed to actuate the contactor to connect and disconnect the power supply. In this state, the ferromagnetic yoke 202 is saturated by the DC magnetic field, deleteriously impacting the ability of the plunger to move up and down (again along arrows 218). Ultimately, the proper function of the contactor 206 may be adversely compromised, and the ability to control the connection and disconnection of the power supply to the magnet is disadvantageously compromised as well. This may result in an undesired quench of the superconducting wires of the superconducting coils.

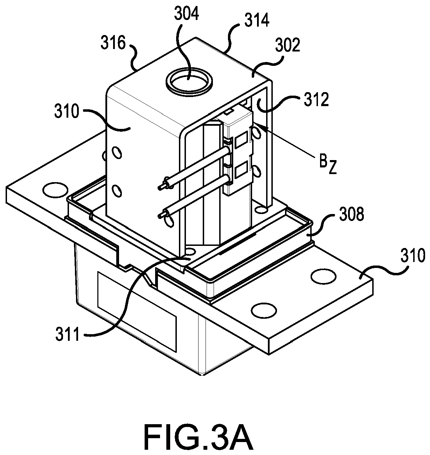

Fig. 3A is a perspective view showing the orientation of a DC magnetic field (shown as B_{z}) relative to contactor 306 comprising a ferromagnetic yoke 302 in accordance with a representative embodiment. Various aspects and details of the presently described representative embodiments are common to those described above in connection with Fig. 1. These common aspects and details may not be repeated in order to avoid obscuring the description of the presently described representative embodiments.

In the depicted embodiment, the plunger is not shown, but as described more fully below, is adapted to be raised to make a connection to a power supply (not shown in Fig. 3A) and lowered to disconnect the power supply and break the thermal path as needed.

The ferromagnetic yoke 302 is made of a ferromagnetic material, with a permanent magnet 304 adapted to function in the magnetic actuation of the plunger of the contactor 306 to make and break the electrical connection. As shown, the contactor 306 is disposed on a base 308 that comprises a ferromagnetic element 311.

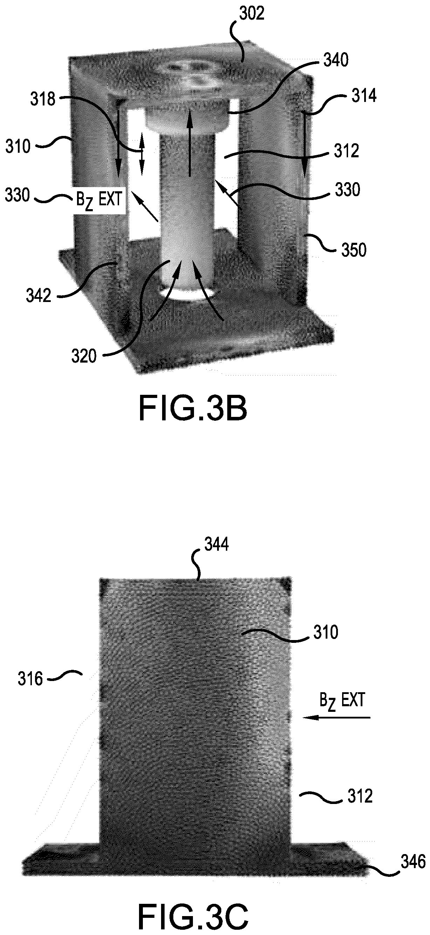

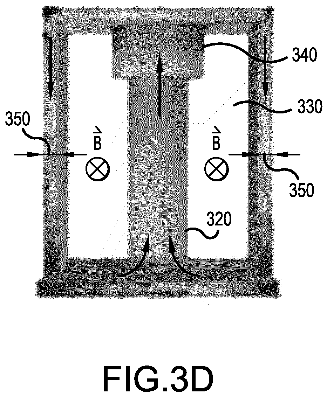

As will be appreciated by one of ordinary skill in the art, a magnetic field traverses the ferromagnetic yoke 302 and is used to effect the mechanical actuation of the plunger (not shown in Fig. 3A). A coil (not shown) embedded in the contactor 306 is used to create a magnetic flux that links the ferromagnetic plunger and the ferromagnetic yoke. In other words, as shown by arrows in Figs. 3B and 3D, the flux flows through the plunger in one direction and returns through the ferromagnetic yoke 302. When the coil is energized to allow current to flow in one direction, this causes the plunger to be attracted to the permanent magnet 304.

As shown in Fig. 3A, and as described more fully below in connection with Figs. 3B and 3C, the ferromagnetic yoke 302 comprises four sides. Two of the sides 310, 314 are substantially solid, and two of the sides 312, 316 are substantially "open." Stated somewhat differently, two open sides 312, 316 have substantially less surface area than the surface area of the two solid sides 310, 314. Rather, and as shown more clearly and described more fully below, the surface area of the two surface area comprises a surface area that is approximately equal to twice the thickness of the ferromagnetic yoke 302. Notably, the thickness of the ferromagnetic yoke, which is seen in Fig. 3A, is shown between the arrows as 350 in Figs. 3B and 3D. As will be appreciated, the surface area of twice the thickness of the ferromagnetic yoke is small compared to the surface area of the sides 310, 314. As will be appreciated, the thickness of the ferromagnetic yoke is dependent on the material selected therefor. In accordance with a representative embodiment, the thickness of the ferromagnetic yoke 302 has a thickness on the order of approximately 1mm.

As shown, in the structure of the representative embodiment of Fig. 3A, the DC magnetic field generated by the superconducting coils is oriented to be incident substantially perpendicular to sides 312, 316 of the ferromagnetic yoke 302. As described below in connection with Figs. 3B and 3D when the DC magnetic field is applied in this manner, the ferromagnetic yoke 302 is not saturated by the DC magnetic field, and the plunger 320 can function as needed to make and break the electrical (and thermal) connection between the power supply and the superconducting coils as noted above.

Figs. 3B-3C show two views of a contactor comprising a ferromagnetic yoke with the orientation of the B field in accordance with a representative embodiment and perpendicular to 312, 316 of the ferromagnetic yoke 302, and the B field density in the ferromagnetic yoke during operation of an MRI apparatus. Notably, other components of the contactor 306 are not shown in Figs. 3B-3C.

Turning to Figs. 3B-3C, the DC magnetic field 330 is turned on, but the function of a plunger 320 is not adversely impacted. Specifically, because the portion of the ferromagnetic yoke 302 that has the DC magnetic field 330 incident perpendicularly thereon is comparatively small (shown at 350 and being approximately twice the thickness of the ferromagnetic yoke 302) the magnetic flux in regions such as first region 340 and second region 342 are not comparatively dark. As such, the DC magnetic field 330 does not induce magnetic fields significantly in these regions. This lower magnetic flux interferes significantly less than in first and second regions 240, 242 when the ferromagnetic yoke and B-field were in the known orientation as described above. As such, magnetic actuation of the contactor is not significantly impacted, and the magnetic field that raises and lowers the plunger 320 (shown by arrows 318) causing the electrical connection and disconnection, respectively, of the power supply (not shown in Fig. 3B) to the superconducting coils of the magnet (not shown in Figs. 3B-3C) is impacted by the DC magnetic field to an acceptable amount. Stated somewhat differently, while it is difficult to eliminate the impact of the DC magnetic field on the magnetic actuation of the plunger 320, Applicants have found that orienting the ferromagnetic yoke 302 in the manner shown in Figs. 3A-3D allows the contactor 306 to connect and disconnect the power supply to the superconducting coils to at least an acceptable degree.

As noted above, when no DC magnetic field is applied, 100% of the closing force is achieved with a contactor. By contrast, when the ferromagnetic yoke is oriented as shown in the known devices of Figs. 2A and 2C, only approximately 74% of the opening force is possible in a 3-Tesla magnetic field, and the contactor experiences a magnetic field between approximately 0.05 Tesla to approximately 0.1 Tesla. By contrast, with the orientation of the ferromagnetic yoke 302 relative to the DC magnetic field of representative embodiments of 3A-3D, approximately 94% of that opening force is retained. This clearly provides a significant improvement to the technical field. Moreover, and as described more fully below, while approximately 87% of the opening force is retained with a configuration comprising only a ferromagnetic shield, with the ferromagnetic shield and the ferromagnetic yoke oriented as shown in Figs. 4A-4B, approximately 98.5% of the opening force is retained. This clearly provides a further significant improvement to the technical field.

Fig. 3D show another view of a contactor comprising ferromagnetic yoke 302 with the orientation of the B field in accordance with a representative embodiment and perpendicular to sides 312, 316 (not shown in Fig. 3D) of the ferromagnetic yoke 302, and the B field density in the ferromagnetic yoke during operation of an MRI apparatus. Notably, other components of the contactor 306 are not shown in Fig. 3D.

As shown in Figs. 3B and 3D, the DC magnetic field 330 is turned on, but the function of a plunger 320 is not adversely impacted. Specifically, because the portion of the ferromagnetic yoke 302 that has the DC magnetic field 330 incident perpendicularly there on is comparatively small (shown at 350 and being approximately twice the thickness of the ferromagnetic yoke 302) the magnetic flux in regions such as first region 340 and second region 342 are not comparatively dark. As such, the DC magnetic field 330 does not saturate the ferromagnetic yoke with magnetic flux significantly in these regions. This lower magnetic flux interferes significantly less than first and second regions 240, 242 when the ferromagnetic yoke and B-field were in the known orientation as described above. As such, magnetic actuation of the contactor is not significantly impacted, and the magnetic field that raises and lowers the plunger 320 (shown by arrows 318) causing the electrical connection and disconnection, respectively, of the power supply (not shown in Fig. 3D) to the superconducting coils of the magnet (not shown in Fig. 3D) is impacted by the DC magnetic field to an acceptable amount. Stated somewhat differently, while it is difficult to eliminate the impact of the DC magnetic field on the magnetic actuation of the plunger 320, Applicants have found that orienting the ferromagnetic yoke 302 in the manner shown in Figs. 3A-3D allows the contactor 306 to connect and disconnect the power supply to the superconducting coils to at least an acceptable degree.

Fig. 4A a perspective view of a contactor 400 comprising a ferromagnetic shield 401 disposed over a ferromagnetic yoke 402 comprising a permanent magnet in accordance with a representative embodiment. Various aspects and details of the presently described representative embodiments are common to those described above in connection with Figs. 1 and 3A-3D. These common aspects and details may not be repeated in order to avoid obscuring the description of the presently described representative embodiments.

As noted above, the ferromagnetic shield 401 comprises a ferromagnetic material having a magnetic permeability (µₘ) having a magnitude to shunt the DC magnetic field (B_{z}) as shown in Fig. 4A) to further improve the function of the mechanically actuated contactor of the presently described representative embodiment.

As shown, the ferromagnetic shield 401 comprises four substantially orthogonal sides, with the top or lid being open as shown. Notably, this is merely illustrative and the top or lid of the ferromagnetic shield 401 may also be provided and comprise a ferromagnetic material as well.

Notably, the "open" sides 412 and its opposing side 416 of the ferromagnetic yoke 402 are oriented so the DC magnetic field is substantially perpendicular thereto. This enables the reduction of induced magnetic fields in the ferromagnetic yoke 402 as described more fully below.

Fig. 4B is a top view of the contactor 400 of Fig. 4A showing B field flux lines traversing the ferromagnetic shield 401 disposed over the ferromagnetic yoke 402 in accordance with a representative embodiment.

Turning to Fig. 4B, the DC magnetic field 430 is incident substantially perpendicularly to one side of the ferromagnetic shield 401. Notably, the in other representative embodiments, the DC magnetic field is not oriented perpendicularly to two sides 412, 416 of the ferromagnetic yoke 402 having substantially less surface area. As will be appreciated, in such embodiments, the greater the magnitude of the component of the DC magnetic field perpendicular to the two sides 412, 416 of the ferromagnetic yoke 402 having substantially less surface area than the other two sides, the less impact the DC magnetic field has on the closing force.

Although not clearly shown in Fig. 4B, the DC magnetic field 430 is also oriented perpendicularly to an open side of the ferromagnetic yoke 402 (i.e., the sides having substantially less surface area than the other two sides of the ferromagnetic yoke 402). In this way, like the action of the ferromagnetic yoke 302 described above, the induction of magnetic fields in the ferromagnetic yoke 402 is minimized to at least an extent to enable an adequate closing force of the magnetically actuated contactor. As noted above, while approximately 87% of the opening force is retained with a configuration comprising only a ferromagnetic shield, with the ferromagnetic shield 401 and the ferromagnetic yoke 402 oriented as shown in Figs. 4A-4B, approximately 98.5% of the opening force is retained.

As noted above, the dimensions of the ferromagnetic shield 401 and the selection of material are factors to be considered when designing the ferromagnetic shield 401. In a non-limiting example, when the ferromagnetic shield 401 comprises carbon-steel, the ferromagnetic shield 401 has a thickness of approximately 2mm to approximately 8 mm.

The width and length of the ferromagnetic shield 401 must also be properly determined. As shown in Figs. 4A and 4B, the length and width of the ferromagnetic shield 401 are chosen to be slightly larger than the dimensions of the ferromagnetic yoke 402 and may be refined through iterations of electromagnetic simulations. For cost-saving reasons, raw stock material dimensions may be selected. In the non-limiting example, the ferromagnetic shield 401 has a width of approximately 50 mm to approximately 70mm and a length of approximately 50 mm to approximately 70 mm.

Because of the comparatively high magnetic permeability of the ferromagnetic shield 401, the incident DC magnetic field follows a path bounded by the ferromagnetic shield 401. To this end, magnetic field lines 432 show the path of the magnetic field induced in the ferromagnetic shield 401. This path adequately prevents induction of magnetic fields in the contactor (not shown in Fig. 4B). Thereby, the deleterious impact of the DC magnetic field 430 on the magnetically actuated contactor is further prevented by the action of the ferromagnetic shield 401. Beneficially, in accordance with various representative embodiments, combination of orienting the ferromagnetic yoke 402 so that the DC magnetic field is incident on an open side with the action of the ferromagnetic shield 401 further improves the shielding of the magnetically actuated contactor to approximately 98.5% of the unencumbered opening force.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. §1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. A magnetically-actuated contactor (306), comprising:
a ferromagnetic plunger (320); and
a ferromagnetic yoke (302) disposed over the ferromagnetic plunger (320), the ferromagnetic yoke (302) comprising four sides, with two of the four sides have substantially less surface area than the other two of the four sides, wherein an external magnetic field is oriented to be substantially perpendicularly to the two sides having substantially less surface area.

2. The apparatus of claim 1, further comprising a permanent magnet (304) is disposed in an upper surface of the ferromagnetic yoke (302), wherein the permanent magnet (304) is adapted to cause the contactor (306) to open and close.

3. The apparatus of claim 2, wherein when the contactor (306) is open, a thermal break exists and when the contactor (306) is closed, current is provided to a magnet.

4. The apparatus of claim 1, wherein the ferromagnetic yoke (302) comprises Iron, Nickel, Cobalt, Neodymium or magnetite (Fe₃O₄).

5. The apparatus of claim 1, wherein the ferromagnetic yoke (302) comprises an alloy of carbon-steel, silicon-steel, permalloy (iron and nickel) or alnico (aluminum, nickel and cobalt).

6. The apparatus of claim 1, further comprising a ferromagnetic shield (401) disposed over the ferromagnetic yoke (302) and substantially covering the four sides of the ferromagnetic yoke (302), wherein the ferromagnetic shield (401) shunts at least another portion the external magnetic field away from the contactor (306).

7. The apparatus of claim 6, wherein the ferromagnetic shield (401) comprises Iron, Nickel, Cobalt, Neodymium or magnetite (Fe₃O₄).

8. The apparatus of claim 6, wherein the ferromagnetic shield (401) comprises an alloy of carbon-steel, silicon-steel, permalloy (iron and nickel) or alnico (aluminum, nickel and cobalt).

9. A magnetic resonance imaging (MRI) device (100), comprising:
an electrically superconductive coil having an opening to receive a subject; and
magnetically-actuated contactor (306), comprising: a ferromagnetic plunger (320); and a ferromagnetic yoke (302) disposed over the ferromagnetic plunger (320), the ferromagnetic yoke (302) comprising four sides, with two of the four sides have substantially less surface area than the other two of the four sides, wherein an external magnetic field is oriented to be substantially perpendicularly to the two sides having substantially less surface area.

10. The MRI device (100) of claim 9, further comprising a permanent magnet (304) is disposed in an upper surface of the ferromagnetic yoke (302), wherein the permanent magnet (304) is adapted to cause the contactor (306) to open and close.

11. The MRI device (100) of claim 10, wherein when the contactor (306) is open, a thermal break exists and when the contactor (306) is closed, current is provided to the superconducting coil.

12. The MRI device (100) of claim 9, wherein the ferromagnetic yoke (302) comprises Iron, Nickel, Cobalt, Neodymium or magnetite (Fe₃O₄).

13. The MRI device (100) of claim 9, wherein the ferromagnetic yoke (302) comprises an alloy of carbon-steel, silicon-steel, permalloy (iron and nickel) or alnico (aluminum, nickel and cobalt).

14. The MRI device (100) of claim 9, further comprising a ferromagnetic shield (401) disposed over the ferromagnetic yoke (302) and substantially covering the four sides of the ferromagnetic yoke (302), wherein the ferromagnetic shield (401) shunts at least another portion of the external magnetic field away from the contactor (306).

15. The MRI device (100) of claim 14, wherein the ferromagnetic shield (401) comprises
Iron, Nickel, Cobalt, Neodymium or magnetite (Fe3O4) or comprises an alloy of carbon-steel, silicon-steel, permalloy (iron and nickel) or alnico (aluminum, nickel and cobalt).
